# EUROPÄISCHE PATENTANMELDUNG

(11) **EP 3 035 376 A1**
(43) Veröffentlichungstag der Anmeldung: **22.06.2016**
(21) Anmeldenummer: 15165412.6
(22) Anmeldetag: 28.04.2015
(51) Int. Cl.: H01L 21/68

(54) **VERFAHREN UND VORRICHTUNG ZUM VORAUSRICHTEN EINES FLACHEN SUBSTRATS**

(30) Priorität: 17.12.2014 DE 102014118833
(71) Anmelder: Mechatronic Systemtechnik GmbH, 9500 Villach (AT)
(72) Erfinder: Oremus, Alexander, 9500 Villach (AT)
(74) Vertreter: Müller & Schubert

(57) **Zusammenfassung**

Die vorliegende Erfindung betrifft ein Verfahren sowie eine Vorrichtung zum Vorausrichten eines flachen Substrats, insbesondere eines Wafers, welches über eine Folie an einem Rahmen angeordnet ist, vor einem nachfolgenden Bearbeitungsprozess. Damit eine solche Vorausrichtung auf einfache Weise durchgeführt werden kann, ist folgendes vorgesehen: a) der Rahmen mit dem daran befindlichen flachen Substrat wird in einer Messvorrichtung, insbesondere auf einer Auflageeinrichtung der Messvorrichtung, angeordnet; b) in der Messvorrichtung werden mittels wenigstens eines Sensorelements Versatzwerte bezüglich des Versatzes des Substrats zum Zentrum der Messvorrichtung und/oder des Versatzes des Rahmens zum Zentrum der Messvorrichtung, insbesondere zum Zentrum der Auflageeinrichtung, ermittelt; c) die ermittelten Versatzwerte werden über eine der Messvorrichtung zugeordnete Schnittstelle an eine Handhabungseinrichtung zum Handhaben des Substrats übertragen; d) die Handhabungseinrichtung wird anhand der empfangenen Versatzwerte entsprechend bewegt, derart, dass der Rahmen mit dem daran befindlichen Substrat ausgerichtet aufgenommen wird oder dass der Rahmen mit dem daran befindlichen Substrat ausgerichtet an einer Zielposition abgeladen wird.

## Beschreibung

Die vorliegende Erfindung betrifft zunächst ein Verfahren zum Vorausrichten eines flachen Substrats, insbesondere eines Wafers, welches über eine Folie an einem Rahmen angeordnet ist, vor einem nachfolgenden Bearbeitungsprozess. Weiterhin betrifft die vorliegende Erfindung auch eine entsprechende Vorrichtung, mit der insbesondere ein solches Verfahren durchgeführt werden kann.

Derartige Verfahren sind im Stand der Technik grundsätzlich bereits bekannt, beispielsweise im Zusammenhang mit der Herstellung und Bearbeitung von Substraten in Form von Wafern. Ein Wafer ist grundsätzlich eine kreisrunde oder viereckige Scheibe, auf der sich elektronische Bauelemente befinden.

Während der Bearbeitung solcher Wafer befinden sich diese in der Regel auf beziehungsweise in einer Bearbeitungsstation, die beispielsweise einen Bearbeitungstisch aufweisen kann. Der Bearbeitungstisch verfügt über eine Halteeinrichtung, auf der der Wafer während der Bearbeitung angeordnet ist, und auf der der Wafer, beispielsweise mittels Vakuum, angesaugt wird oder ist.

Vor Beginn einer Bearbeitung in der Bearbeitungsstation befindet sich der zu bearbeitende Wafer in der Regel zunächst in einer Lagerreinrichtung. Hierbei kann es sich um eine oder mehrere Lagerkassette(n), so genannte FOUPs (Front Opening Unified Pod) oder dergleichen handeln, wobei in der Lagereinrichtung üblicherweise eine größere Anzahl von Wafern gelagert ist. Damit die Wafer transportiert werden können, ist nicht selten ein Rahmen vorgesehen, der den Wafer umgibt, und an dem der Wafer befestigt ist. Beispielswiese kann der Wafer über eine Folie an dem Rahmen angeordnet, beispielsweise anlaminiert sein. Um den Wafer einem Bearbeitungsprozess zuzuführen, muss dieser aus der Lagereinrichtung zu dem Bearbeitungstisch transportiert werden. Dies kann über eine Handhabungseinrichtung erfolgen, bei der es sich beispielsweise um einen Roboterarm handelt. Die Handhabungseinrichtung greift den Rahmen mit dem über die Folie daran befindlichen Wafer aus der Lagereinrichtung und transportiert die Rahmen-Wafer-Einheit zu dem Bearbeitungstisch. Beim Bearbeitungstisch kommt es darauf an, dass der Wafer in der erforderlichen, prozessspezifischen Weise ausgerichtet ist. Dadurch, dass der Wafer über die Folie an dem Rahmen angeordnet ist, kann es aber passieren, dass der Wafer und/oder der Rahmen einen Versatz aufweist/aufweisen, was sich, sofern der Versatz nicht erkannt und behoben wird, bei den nachfolgenden Bearbeitungsprozessen als sehr nachteilig auswirkt und den Wafer im schlimmsten Fall unbrauchbar macht.

Es besteht deshalb das Bedürfnis, einen solchen Versatz nicht nur zu erkennen, sondern auch zu beheben. Hierzu sind im allgemeinen Stand der Technik durchaus bereits Lösungen bekannt, die aber sehr aufwändig sind.

Der vorliegenden Erfindung liegt deshalb die Aufgabe zugrunde, ein Verfahren sowie eine Vorrichtung der eingangs genannten Art derart weiterzubilden, dass auf einfache Weise ein flaches Substrat, welches über eine Folie an einem Rahmen angeordnet ist, vor einem nachfolgenden Bearbeitungsschritt vorausgerichtet werden kann.

Diese Aufgabe wird erfindungsgemäß gelöst durch das Verfahren mit den Merkmalen gemäß dem unabhängigen Patentanspruch 1 sowie durch die Vorrichtung mit den Merkmalen gemäß dem unabhängigen Patentanspruch 10.

Weitere Merkmale und Details der Erfindung ergeben sich aus den Unteransprüchen, der Beschreibung sowie den Zeichnungen. Dabei gelten Merkmale und Details, die im Zusammenhang mit dem erfindungsgemäßen Verfahren beschrieben sind, stets vollumfänglich auch im Zusammenhang mit der erfindungsgemäßen Vorrichtung, und umgekehrt, so dass hinsichtlich der Offenbarung der einzelnen Erfindungsaspekte stets wechselseitig zu dem jeweils anderen Erfindungsaspekt vollinhaltlich Bezug genommen und auf die entsprechenden Ausführungen verwiesen wird.

Die vorliegende Erfindung basiert auf dem Grundgedanken, dass nunmehr eine besonders ausgebildete Messvorrichtung zum Einsatz kommt, die auch als Pre-Aligner bezeichnet werden kann, und dass mittels dieser Messvorrichtung der Versatz des Substrats zum Zentrum der Messvorrichtung und/oder der Versatz des Rahmens zum Zentrum der Messvorrichtung ermittelt wird.

Gemäß dem ersten Aspekt der vorliegenden Erfindung wird ein Verfahren zum Vorausrichten eines flachen Substrats, insbesondere eines Wafers, welches über eine Folie an einem Rahmen angeordnet ist, vor einem nachfolgenden Bearbeitungsprozess, bereitgestellt, das durch folgende Schritte gekennzeichnet ist:
a) der Rahmen mit dem daran befindlichen flachen Substrat wird in einer Messvorrichtung, insbesondere auf einer Auflageeinrichtung der Messvorrichtung, angeordnet;
b) in der Messvorrichtung werden mittels wenigstens eines Sensorelements Versatzwerte bezüglich des Versatzes des Substrats zum Zentrum der Messvorrichtung und/oder des Versatzes des Rahmens zum Zentrum der Messvorrichtung, insbesondere zum Zentrum der Auflageeinrichtung, ermittelt;
c) die ermittelten Versatzwerte werden über eine der Messvorrichtung zugeordnete Schnittstelle an eine Handhabungseinrichtung zum Handhaben des Substrats übertragen;
d) die Handhabungseinrichtung wird anhand der empfangenen Versatzwerte entsprechend bewegt, derart, dass der Rahmen mit dem daran befindlichen Substrat ausgerichtet aufgenommen wird oder dass der Rahmen mit dem daran befindlichen Substrat ausgerichtet an einer Zielposition abgeladen wird.

Die vorliegende Erfindung betrifft gemäß diesem ersten Aspekt folglich ein Verfahren zum Vorausrichten eines flachen Substrats. Grundsätzlich ist die Erfindung nicht auf bestimmte Arten von Substraten beschränkt. Bei einem Substrat kann es sich generell um eine Unterlage oder Grundlage handeln. Beispielsweise kann es sich bei dem Substrat um einen wie eingangs beschriebenen Wafer handeln, so dass das Verfahren bevorzugt zum Vorausrichten von Wafern verwendet wird. Besonders bevorzugt wird das Verfahren für Wafer mit einem Durchmesser von 300mm eingesetzt, wobei die Erfindung natürlich nicht auf diese bestimmten Waferdurchmesser beschränkt ist.

Vorausrichten bedeutet im Zusammenhang mit der vorliegenden Erfindung insbesondere, dass das Substrat in eine bestimmte Richtung gebracht wird, und zwar bevor das Substrat einem nachfolgenden Bearbeitungsprozess unterzogen wird. Das Vorausrichten wird beispielsweise auch als Pre-Aligning bezeichnet. Eine Vorausrichtung stellt somit insbesondere ein Lage- und Winkelkorrigiertes Bereitstellen des Rahmens und/oder des Substrats dar.

Dabei ist erfindungsgemäß vorgesehen, dass das Substrat über eine Folie an einem Rahmen angeordnet ist. Der Rahmen umgibt dabei das Substrat, so dass sich das Substrat innerhalb des Rahmens befindet und von diesem, vorzugsweise allseitig, umgeben ist. Zwischen dem Substrat und der Rahmen befindet sich bevorzugt ein Zwischenraum. Damit das Substrat dennoch am Rahmen gehalten werden kann, ist vorgesehen, dass das Substrat über eine Folie an dem Rahmen angeordnet ist. Dabei ist bevorzugt vorgesehen, dass die Folie sowohl an dem Substrat als auch an dem Rahmen anlaminiert ist.

Erfindungsgemäß ist das Verfahren durch die nachfolgend näher beschriebenen Schritte gekennzeichnet.

Zunächst wird der Rahmen mit dem über die Folie daran befindlichen flachen Substrat in einer Messvorrichtung angeordnet. Insbesondere ist vorgesehen, dass das der Rahmen mit dem daran befindlichen Substrat auf oder in der Messvorrichtung abgelegt wird. Dazu kann die Messvorrichtung insbesondere eine Auflageeinrichtung aufweisen. Grundsätzlich ist die vorliegende Erfindung nicht auf bestimmte Ausgestaltungen für die Messvorrichtung beschränkt. Ebenso ist die Erfindung nicht auf bestimmte Ausführungsformen für die Auflageeinrichtung beschränkt. Einige bevorzugte Ausführungsformen hierzu werden hinsichtlich deren konstruktiver Ausgestaltung im Zusammenhang mit der erfindungsgemäßen Vorrichtung weiter unten in größerem Detail beschrieben, so dass an dieser Stelle zur Vermeidung von Wiederholungen hinsichtlich der konstruktiven Ausgestaltung auf die entsprechenden Ausführungen weiter unten vollinhaltlich Bezug genommen und verwiesen wird. Funktional gesehen ist für das Verfahren an dieser Stelle vorgesehen, dass der Rahmen mit dem daran befindlichen Substrat auf oder in der Messvorrichtung, insbesondere auf einer Auflageeinrichtung der Messvorrichtung, abgelegt wird.

In einem nächsten Schritt kommen nun besonders ausgebildete Sensorelemente innerhalb der Messvorrichtung zum Einsatz. Dabei ist vorgesehen, dass wenigstens ein solches Sensorelement vorgesehen ist. Bevorzugt sind jedoch mindestens zwei solcher Sensorelemente vorgesehen.

Gemäß diesem Verfahrensschritt werden in der Messvorrichtung mittels wenigstens eines Sensorelements Versatzwerte bezüglich des Versatzes des Substrats zum Zentrum der Messvorrichtung und/oder des Versatzes des Rahmens zum Zentrum der Messvorrichtung, insbesondere zum Zentrum der Auflageeinrichtung, ermittelt. Bei dem Versatz handelt es sich insbesondere um eine Abweichung von der erforderlichen Position. Im vorliegenden Fall bedeutet Versatz insbesondere, dass der Mittelpunkt des Substrats und/oder der Mittelpunkt des Rahmens vom Zentrum der Messvorrichtung abweichen, was insbesondere bedeutet, dass sich die Mittelpunkte des Rahmens und/oder des Substrats außerhalb des Zentrums der Messvorrichtung befinden. Der Versatz kann beispielsweise auch als Offset bezeichnet werden.

Grundsätzlich ist es für das Verfahren ausreichend, wenn ein einziges Sensorelement vorgesehen ist, mittels dem entweder Versatzwerte bezüglich des Versatzes des Substrats, oder aber Versatzwerte bezüglich des Versatzes des Rahmens ermittelt werden. Bevorzugt ist jedoch vorgesehen, dass zwei solcher Sensorelemente vorgesehen sind, wobei über ein erstes Sensorelement Versatzwerte bezüglich des Versatzes des Substrats ermittelt werden, und wobei über ein zweites Sensorelement Versatzwerte bezüglich des Versatzes des Rahmens ermittelt werden.

Das Ermitteln von Versatzwerten bedeutet dabei insbesondere, dass diese Versatzwerte gemessen und/oder berechnet werden.

Insbesondere, wenn zur Ermittlung der Versatzwerte eine Berechnung erforderlich ist, ist eine Rechnereinrichtung vorgesehen, die beispielsweise Bestandteil der Messvorrichtung sein kann, oder aber die mit der Messvorrichtung kommuniziert. Bevorzugt ist vorgesehen, dass mittels der Sensorelemente Messwerte erfasst werden, und dass aus diesen erfassten Messwerten anschließend Versatzwerte, entweder direkt oder indirekt, ermittelt werden.

Grundsätzlich ist die vorliegende Erfindung nicht auf bestimmte Ausgestaltungen für die Messvorrichtung, die Sensorelemente und die Rechnereinrichtung beschränkt. Einige bevorzugte Ausführungsformen hierzu werden hinsichtlich deren konstruktiver Ausgestaltung im Zusammenhang mit der erfindungsgemäßen Vorrichtung weiter unten in größerem Detail beschrieben, so dass an dieser Stelle zur Vermeidung von Wiederholungen hinsichtlich der konstruktiven Ausgestaltung auf die entsprechenden Ausführungen weiter unten vollinhaltlich Bezug genommen und verwiesen wird. Funktional gesehen ist für das Verfahren an dieser Stelle vorgesehen, dass der Versatz gemessen wird, indem beispielsweise über die Sensorelemente Messwerte erfasst werden, aus denen sich dann Versatzwerte ermitteln lassen. Aus den ermittelten Versatzwerten wird bestimmt, wie der Rahmen und/der das Substrat liegt/liegen.

In einem nächsten Schritt werden die ermittelten Versatzwerte über eine der Messvorrichtung zugeordnete Schnittstelle an eine Handhabungseinrichtung zum Handhaben des Substrats übertragen. Dabei ist insbesondere vorgesehen, dass die Schnittstelle einer wie vorstehend beschriebenen Rechnereinrichtung zugeordnet ist, in der die Versatzwerte tatsächlich ermittelt werden. Sofern die Rechnereinrichtung nicht Bestanteil der Messvorrichtung an sich ist, ist die Schnittstelle in einem solchen Fall nicht Bestandteil der Messvorrichtung, sondern Bestandteil der Rechnereinrichtung. In einer bevorzugten Ausführungsform ist die Rechnereinrichtung jedoch Bestanteil der Messvorrichtung. Über die Schnittstelle werden die Versatzwerte, insbesondere in Form von Daten, an die Handhabungseinrichtung übergeben. Dabei ist die Erfindung nicht auf bestimmte Typen von Schnittstellen beschränkt. Bei der Schnittstelle kann es sich beispielsweise um eine drahtlose, oder aber um eine drahtgebundene Schnittstelle handeln, die insbesondere zur unidirektionalen, aber auch zur bidirektionalen Übertragung von Daten ausgebildet sein kann. Zur Durchführung einer Kommunikation weist auch die Handhabungseinrichtung bevorzugt eine entsprechende, korrespondierende Schnittstelle auf, über die die von der Messvorrichtung übertragenen Daten empfangen werden können.

Die Erfindung ist nicht auf bestimmte Arten von Handhabungseinrichtungen beschränkt. Beispielsweis kann es sich bei einer solchen Handhabungseinrichtung um eine Robotereinrichtung mit wenigstens einem Roboterarm handeln.

Auch bezüglich der vorgenannten Komponenten ist die vorliegende Erfindung grundsätzlich nicht auf bestimmte Ausgestaltungen beschränkt. Einige bevorzugte Ausführungsformen hierzu werden hinsichtlich deren konstruktiver Ausgestaltung im Zusammenhang mit der erfindungsgemäßen Vorrichtung weiter unten in größerem Detail beschrieben, so dass an dieser Stelle zur Vermeidung von Wiederholungen hinsichtlich der konstruktiven Ausgestaltung auf die entsprechenden Ausführungen weiter unten vollinhaltlich Bezug genommen und verwiesen wird. Funktional gesehen ist für das Verfahren an dieser Stelle vorgesehen, dass die über die Messvorrichtung ermittelten Versatzwerte an die Handhabungseinrichtung übertragen werden, und dass die Handhabungseinrichtung anhand dieser übertragenen Versatzwerte anschließend entsprechend angesteuert und bewegt wird.

Dies geschieht erfindungsgemäß in einem nächsten Schritt in einer Weise, dass die Handhabungseinrichtung anhand der empfangenen Versatzwerte entsprechend bewegt wird, derart, dass der Rahmen mit dem daran befindlichen Substrat ausgerichtet aufgenommen wird oder dass der Rahmen mit dem daran befindlichen Substrat ausgerichtet an einer Zielposition abgeladen wird. Das bedeutet, dass, nachdem die Versatzwerte an die Handhabungseinrichtung übergeben worden sind, die Handhabungseinrichtung den Rahmen mit dem über die Folie daran befindlichen Substrat, der sich noch in der Messvorrichtung befindet, entsprechend anfährt, damit der Rahmen mit dem Wafer in der erforderlichen Weise gerichtet aufgenommen wird. Gemäß einer anderen bevorzugten Ausführungsform kann jedoch vorgesehen sein, dass die Handhabungseinrichtung den Rahmen mit dem daran befindlichen Substrat zunächst ohne Berücksichtigung der Versatzwerte aufnimmt, und dass der Rahmen mit dem Substrat anschließend in der erforderlichen Weise gerichtet auf einem Bearbeitungstisch abgelegt wird, wo der nachfolgende Bearbeitungsprozess gestartet wird. In beiden Fällen wird aber erreicht, dass der Rahmen mit dem daran befindlichen Substrat, trotz eines bestehenden Versatzes, in der erforderlichen Weise gerichtet auf dem Bearbeitungstisch abgelegt wird, bevor der nächste Bearbeitungsprozess beginnt.

Bei dem erfindungsgemäßen Verfahren ist somit vorgesehen, dass die erforderliche Ausrichtung des Rahmens und/oder des daran befindlichen Substrats nicht, oder aber nur in begrenztem Maße, in der Messvorrichtung an sich vorgenommen wird. Dort werden nur die erforderlichen Werte in Form von Versatzwerten erzeugt, die für die erforderliche Ausrichtung benötigt werden und an die Handhabungseinrichtung, insbesondere zur Korrektur der Übergabeposition, übermittelt. Die eigentliche Ausrichtung erfolgt dann durch die Handhabungseinrichtung anhand der empfangenen Versatzwerte.

Durch das erfindungsgemäße Verfahren wird damit eine einfache, kostengünstige Lösung geschaffen, um eine Fehlerkorrektur hinsichtlich der Ausrichtung vor dem nächsten Bearbeitungsprozess für das Substrat durchzuführen.

Ein etwas konkreteres Ausführungsbeispiel zur Durchführung des Verfahrens wird nachfolgend beschrieben. Zunächst wird der Rahmen mit dem über die Folie daran anlaminierten Substrat in die Messvorrichtung eingebracht und dort auf einer Auflageeinrichtung abgelegt. Nun wird der Versatz des Rahmens und/oder des Substrats bestimmt. Anschließend wir die Handhabungseinrichtung entsprechend instruiert, damit die Handhabungseinrichtung weiß, wo sie den Rahmen mit dem daran befindlichen Substrat angreifen muss, damit das Substrat in der erforderlichen Ausrichtung, insbesondere mittig, auf dem Bearbeitungstisch für den nächsten Bearbeitungsprozess aufgebracht werden kann.

Nachfolgend werden einige bevorzugte Ausführungsbeispiele beschrieben, wie die entsprechenden Versatzwerte ermittelt werden können.

In einer bevorzugten Ausführungsform wird über das wenigstens eine Sensorelement der Mittelpunkt des Substrats und/oder des Rahmens bestimmt, wobei daraus Versatzwerte bezüglich des Versatzes des Substrats und/oder des Versatzes des Rahmens ermittelt werden. Hierbei wird insbesondere der Mittelpunkt des Substrats und/oder des Rahmens bestimmt. In einer alternativen Ausführungsform, oder aber in bevorzugter Weiterbildung der vorgenannten Ausführungsform wird über das wenigstens eine Sensorelement die Kante des Substrats und/oder des Rahmens ermittelt. Bei der Kante handelt es sich insbesondere um die Außenkante oder die Außenkontur des Substrats und/oder des Rahmens. Daraus werden dann Versatzwerte bezüglich des Versatzes des Substrats und/oder des Versatzes des Rahmens ermittelt.

In einer bevorzugten Ausführungsform wird/werden die Außenkante des Rahmens und/oder die Außenkante des Substrats vermessen. Aus den ermittelten Messwerten wird eine Messkurve erzeugt, wobei die erzeugte Messkurve anschließend ausgewertet wird, insbesondere derart, dass daraus der Versatz in X-Richtung und in Y-Richtung zum Zentrum der Messvorrichtung bestimmt wird. Bei dieser Ausführungsform sind zwei Sensorelemente vorgesehen, wobei ein erstes Sensorelement die Kante des Substrats vermisst, während das andere Sensorelement die Kante des Rahmens vermisst.

Das Verfahren ist in weiterer Ausgestaltung bevorzugt ausgebildet, dass in der Messvorrichtung der Versatz des Mittelpunkts des Substrats zum Mittelpunkt des Rahmens errechnet wird.

In weiterer Ausgestaltung ist bevorzugt vorgesehen, dass zusätzlich der Durchmesser des Substrats ermittelt wird, insbesondere indem der Durchmesser über zwei oder mehr Punkte, bevorzugt über vier Punkte, errechnet wird. Damit kann insbesondere auch die Rundheit des Substrats bestimmt werden.

Bevorzugt ist nämlich vorgesehen, dass das erfindungsgemäße Verfahren in mehreren Abschnitten eines Bearbeitungsverfahrens zum Einsatz kommt. Dies soll anhand eines Ausführungsbeispiels verdeutlicht werden. Beispielsweise ist vorgesehen, dass das Verfahren gleich zu Beginn eines Bearbeitungsverfahrens zum Einsatz kommt, wenn der Rahmen mit dem über die Folie daran angeordneten Substrat, beispielsweise einem Wafer, über die Handhabungseinrichtung aus einer Lagereinrichtung herausgenommen und einem ersten Bearbeitungsprozess zugeführt werden soll. Bei einem solchen Bearbeitungsprozess kann es sich beispielsweise um einen Schneidprozess handeln, bei dem das Substrat von dem Rahmen losgeschnitten wird. Damit das Substrat für die weiteren Bearbeitungsschritte richtig ausgerichtet ist, wird zunächst das erfindungsgemäße Verfahren durchgeführt. Im weiteren Verlauf kann das Substrat einer Reihe weiterer Bearbeitungsprozesse unterzogen werden, beispielsweise auch einem Expandierprozess. Am Ende eines solchen Expandierprozesses ist es bevorzugt gewünscht zu wissen, wie es um den Durchmesser des Substrats, und insbesondere auch um dessen Rundheit bestellt ist. Zu diesem Zweck kann das Substrat, das dann wiederum über eine Folie an einem Rahmen befestigt ist, abschließend noch einmal einem erfindungsgemäßen Verfahren unterzogen werden, damit der Rahmen mit dem daran befindlichen Substrat in der erforderlichen Weise abschließend wieder in der Lagereinrichtung gelagert werden kann. Zu diesem Zeitpunkt wird dann bevorzugt auch der Durchmesser des Substrats errechnet und die Rundheit des Substrats nach dem Expandieren bestimmt. Ebenso kann der Versatz der Mittelpunkte von Substrat zu Rahmen errechnet werden.

Wie weiter oben schon ausgeführt wurde, wird der errechnete Versatz des Rahmens zum Substrat von der Messvorrichtung über die Schnittstelle an die Handhabungseinrichtung bevorzugt zur Korrektur der Übergabeposition übermittelt.

In weiterer Ausgestaltung wird bevorzugt in der Messvorrichtung die Winkelorientierung des Substrats und/oder des Rahmens ermittelt. Dabei wird die Winkelposition insbesondere in der Messvorrichtung korrigiert.

Bevorzugt ist vorgesehen, dass das Substrat und/oder der Rahmen unter dem wenigstens einen Sensorelement gedreht wird/werden. Dabei ist insbesondere eine Drehung um 360 Grad vorgesehen. Die Drehung lässt sich über einen geeigneten Antrieb realisieren. Dabei ist die Erfindung nicht auf bestimmte Typen von Antrieben beschränkt. Einige bevorzugte Ausführungsbeispiele hierzu werden im weiteren Verlauf im Zusammenhang mit der erfindungsgemäßen Vorrichtung weiter unten in größerem Detail beschrieben, so dass an dieser Stelle zur Vermeidung von Wiederholungen auf die Ausführungen weiter unten vollinhaltlich Bezug genommen und verwiesen wird.

In weiterer Ausgestaltung wird über ein Sensorelement zur Materialbestimmung bevorzugt das Material des Rahmens bestimmt. Alternativ oder zusätzlich kann zur Bestimmung der Identität des Rahmens ein an dem Rahmen befindlicher Code über eine Leseeinrichtung gelesen werden und/oder es kann zur Bestimmung der Identität des Substrats ein an dem Substrat befindlicher Code über eine Leseeinrichtung gelesen werden. Dabei ist die Erfindung nicht auf bestimmte Typen von Sensorelementen und/oder Leseeinrichtungen beschränkt. Einige bevorzugte Ausführungsbeispiele hierzu werden im weiteren Verlauf im Zusammenhang mit der erfindungsgemäßen Vorrichtung weiter unten in größerem Detail beschrieben, so dass an dieser Stelle zur Vermeidung von Wiederholungen auf die Ausführungen weiter unten vollinhaltlich Bezug genommen und verwiesen wird.

Gemäß einem zweiten Aspekt der Erfindung wird eine Vorrichtung zum Vorausrichten eines flachen Substrats, insbesondere eines Wafers, welches über eine Folie an einem Rahmen angeordnet ist, vor einem nachfolgenden Bearbeitungsprozess, bereitgestellt, aufweisend eine Messvorrichtung, mit einer Auflageeinrichtung zum Aufnehmen des Rahmens mit dem daran befindlichen Substrat. Bei der Auflageeinrichtung kann es sich beispielsweise um eine Auflage mit Vakuum-Sauger handeln, insbesondere um eine entsprechend ausgebildete Rahmenauflage. Weiterhin ist die Auflageeinrichtung, insbesondere über einen Antrieb um 360 Grad, drehbar. Bei dem Antrieb kann es sich beispielsweise um einen Servo-Getriebemotor handeln, der die Auflageeinrichtung drehbar antreibt. Zudem weist die Vorrichtung wenigstens ein Sensorelement zum Ermitteln des Versatzes des Substrats zum Zentrum der Messvorrichtung und/oder wenigstens ein Sensorelement zum Ermitteln des Versatzes des Rahmens zum Zentrum der Messvorrichtung auf. Derartige Sensorelemente werden weiter unten noch näher erläutert. Schließlich verfügt die Vorrichtung über eine Schnittstelle zum Übertragen der ermittelten Versatzwerte an eine Handhabungseinrichtung zum Handhaben des Substrats. Geeignete Schnittstellen sind beispielhaft weiter oben im Zusammenhang mit dem erfindungsgemäßen Verfahren schon genannt worden.

Wie im Zusammenhang mit dem erfindungsgemäßen Verfahren schon erläutert wurde, weist die Vorrichtung bevorzugt eine Rechnereinrichtung auf, in der die Versatzwerte aus den über die Sensorelemente ermittelten Werte entweder direkt oder indirekt erzeugt oder berechnet werden. Die Rechnereinrichtung ist in jedem Fall Bestandteil der Vorrichtung und in besonderer Ausgestaltung Bestandteil der Messvorrichtung. Hinsichtlich der Ausgestaltung und Funktionsweise der Rechnereinrichtung wird an dieser Stelle auch auf die entsprechenden Ausführungen weiter oben im Zusammenhang mit dem erfindungsgemäßen Verfahren vollinhaltlich Bezug genommen und verwiesen.

In weiterer Ausgestaltung weist die Vorrichtung eine Handhabungseinrichtung zum Handhaben des Substrats auf. Dabei ist die Erfindung nicht auf bestimmte Typen von Handhabungseinrichtungen beschränkt. Bevorzugt handelt es sich bei der Handhabungseinrichtung um einer Robotereinrichtung mit wenigstens einem Roboterarm. Am Ende der Handhabungseinrichtung befindet sich dann eine Einrichtung zum Aufnehmen des Rahmens mit dem daran angeordneten Substrat. Weiterhin weist die die Handhabungseinrichtung eine Schnittstelle zum Empfangen von Versatzwerten von der Messvorrichtung auf, wobei die Schnittstelle kompatibel mit der Schnittstelle der Messvorrichtung ist. Über die beiden Schnittstellen können Daten unidirektional oder bidirektional ausgetauscht werden. Im einfachsten Fall ist ein unidirektionaler Datenaustausch von der Messvorrichtung zur Handhabungseinrichtung ausreichend. Schließlich ist die Handhabungseinrichtung bevorzugt derart bereitgestellt, dass sie in der Lage ist, dass sie anhand der empfangenen Versatzwerte entsprechend bewegt wird, derart, dass der Rahmen mit dem daran befindlichen Substrat ausgerichtet aufgenommen wird oder dass der Rahmen mit dem daran befindlichen Substrat ausgerichtet an einer Zielposition abgeladen wird. Diesbezüglich wird auch auf die entsprechenden Ausführungen zum erfindungsgemäßen Verfahren weiter oben vollinhaltlich Bezug genommen und verwiesen.

In bevorzugter Ausgestaltung ist/sind das wenigstens eine Sensorelement zum Ermitteln des Versatzes des Substrats zum Zentrum der Messvorrichtung und/oder das wenigstens eine Sensorelement zum Ermitteln des Versatzes des Rahmens zum Zentrum der Messvorrichtung als optisches Sensorelement, insbesondere als CCD-Laser-Sensorelement, ausgebildet. Grundsätzlich ist die Erfindung nicht auf bestimmte Typen von Sensorelementen beschränkt. Beispielsweise kann es sich bei den Sensorelementen um optische Linearsensoren, um Lasersensoren vom Durchstrahltypus (CCD Thrubeam Type Laser Sensor), um Lichtband-Kantensensoren, um Mehrzweck-CCD-Laser Mikrometer oder dergleichen handeln. Solche Sensorelemente funktionieren grundsätzlich in einer Weise, dass ein Lichtstrahl von einem Emitter zu einem räumlich davon getrennten Empfänger gerichtet wird und verläuft. Wird nun die Kante eines Substrats oder eines Rahmens in diesen Laserstrahl hineingehalten, kann die Kantenposition aufgrund von Reflexionsvorgängen und Lichtstrahlunterbrechungsvorgängen erkannt und an ein Steuerungsgerät ausgegeben werden. Derartige Sensorelemente sind im Stand der Technik an sich bekannt und dem Fachmann geläufig. Im Zusammenhang mit der vorliegenden Erfindung ist bevorzugt vorgesehen, dass die Sensorelemente in der Lage sind, die Kante eines Substrats durch eine Folie hindurch, mit der das Substrat an dem Rahmen angeordnet ist, hindurch zu erkennen. Durch die Verwendung entsprechender Sensorelemente wird es möglich, auf Sensorelemente zur Bildverarbeitung, die aufwändiger sind, und die ansonsten zum Einsatz kommen müssten, zu verzichten.

In weiterer Ausgestaltung kann die Vorrichtung zusätzlich ein Sensorelement zum Bestimmen des Rahmenmaterials aufweisen. Dadurch kann das Material des Rahmens ermittelt werden. Beispielsweise kann ermittelt werden, ob der Rahmen aus Kunststoff oder aus Metall besteht. Ein entsprechendes Sensorelement kann beispielsweise ein induktives Sensorelement sein. Alternativ oder in weiterer Ausgestaltung kann die Vorrichtung zur Bestimmung der Identität des Rahmens eine Leseeinrichtung zum Lesen eines an dem Rahmen befindlichen Codes aufweisen. Beispielsweise kann die Leseeinrichtung zum Lesen eines Barcodes oder eines OCR-Textes (Optical Character Recognition) ausgebildet sein, wobei der Barcode oder der OCR-Text insbesondere die Rahmen-ID darstellt oder beinhaltet. Alternativ oder in weiterer Ausgestaltung kann die Vorrichtung zur Bestimmung der Identität des Substrats eine Leseeinrichtung zum Lesen eines an dem Substrat befindlichen Codes aufweisen. Bei dem Code kann es sich beispielsweise um einen Barcode oder einen OCR-Text handeln wobei der Code insbesondere die Substrat-ID darstellt oder beinhaltet. Derartige Sensorelemente und Leseeinrichtungen sind im Stand der Technik an sich bekannt und dem Fachmann geläufig. Die vorliegende Erfindung ist demnach nicht auf bestimmte Typen von Sensorelementen oder Leseeinrichtungen beschränkt.

Bevorzugt weist die erfindungsgemäße Vorrichtung Mittel zur Durchführung des wie vorstehend beschriebenen erfindungsgemäßen Verfahrens auf, so dass hinsichtlich der Ausgestaltung und Funktionsweise der erfindungsgemäßen Vorrichtung vollinhaltlich auch auf die Ausführungen zum erfindungsgemäßen Verfahren Bezug genommen und verwiesen wird.

Die erfindungsgemäße Lösung kann auch wie folgt beschrieben werden:
Die Messvorrichtung, die Bestandteil der erfindungsgemäßen Vorrichtung zum Vorausrichten eines flachen Substrats ist, und die auch als Frame Pre-Aligner bezeichnet werden kann, ist insbesondere ein Messgerät, das das am Rahmen (Frame) angeordnete Substrat, insbesondere einen Wafer, unter einem oder mehreren Sensoren um 360 Grad dreht und folgende Ergebnisse liefert:
   - Vermessen der Außenkontur des Rahmens. Es entsteht eine Messkurve welche so ausgewertet wird, dass die Winkelorientierung, der Versatz in X und Y zum Messvorrichtungs-Zentrum, bei dem es sich um das Zentrum der Messvorrichtung handelt, bestimmt werden kann.
   - Das Material des Frames (Kunststoff oder Metall) wird über einen induktiven Sensor ermittelt
   - Vermessen der Außenkontur des Substrats, wobei die Auswertung gleich wie beim Rahmen ist. Zusätzlich wird noch der Durchmesser über 4 Punkte errechnet und die Rundheit des Substrats, insbesondere nach einem Expandieren, bestimmt. Der Versatz der Mittelpunkte von Substrat zu Rahmen wird ebenso errechnet.
   - Lesen des Barcodes (Frame-ID) der Etikette am Rahmen
   - Lesen des OCR-Textes (Wafer-ID) am Substratrand

Die ermittelten Werte für den Versatz in X und Y von Rahmen oder Substrat werden der Handhabungseinrichtung, beispielsweise dem Roboter, zur Korrektur der Übergabeposition übermittelt. Die Winkelorientierung wird an der Messvorrichtung korrigiert.

Die Messvorrichtung kann also alleine keine vollständige Vorausrichtung (Aligning), das heißt ein Lage- und Winkelkorrigiertes Bereitstellen des Substrats, im Zentrum der Messvorrichtung, durchführen, sondern nur im System gemeinsam mit einer geeigneten Handhabungseinrichtung, welche bevorzugt auch quer zur Handlingsachse verfahren kann.

Die erfindungsgemäße Vorrichtung kann die Kanten des Rahmens und des Substrats detektieren. Weiterhin kann die Vorrichtung Codes auf dem Rahmen und auf dem Substrat lesen. Dies hat eine Reihe von Vorteilen, wie nachfolgend auch anhand von bevorzugten Ausführungsbeispielen unter Bezugnahme auf die beiliegenden Zeichnungen näher erläutert wird. Es zeigen
- Figur 1: in schematischer Ansicht ein Ausführungsbeispiel einer erfindungsgemäßen Vorrichtung zum Vorausrichten eines flachen Substrats;
- Figur 2: in perspektivischer Ansicht eine Messvorrichtung, die Bestandteil der erfindungsgemäßen Vorrichtung zum Vorausrichten eines flachen Substrats ist;
- Figur 3: eine Draufsicht auf die in Figur 2 dargestellte Messvorrichtung;
- Figur 4: eine erste Schnittansicht der Messvorrichtung aus Figur 3 entlang der in Figur 3 dargestellten Schnittlinie A-A; und
- Figur 5: eine zweite Schnittansicht der Messvorrichtung aus Figur 3 entlang der in Figur 3 dargestellten Schnittlinie B-B.

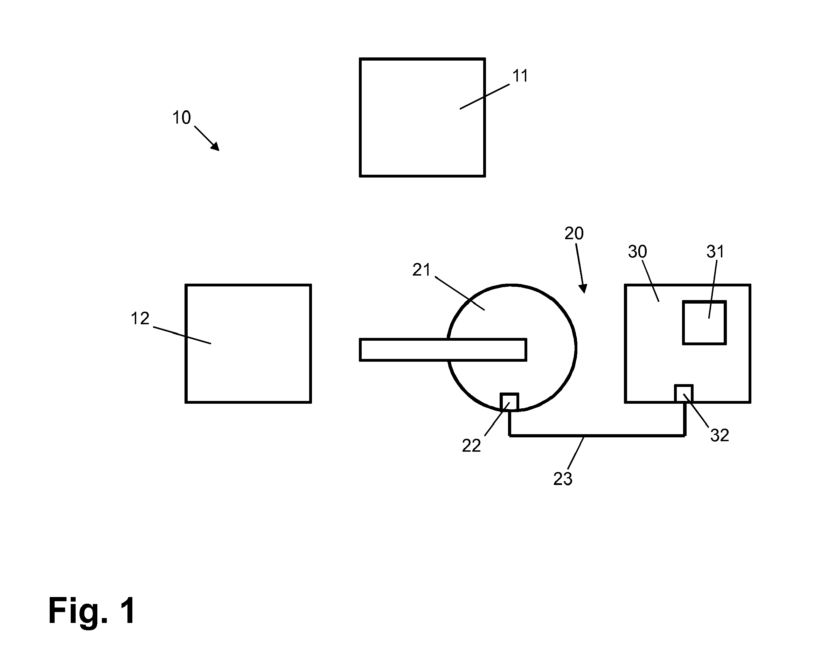

In Figur 1 ist eine Bearbeitungsstation 10 für flache Substrate in Form von Wafern dargestellt. Der Bearbeitungsstation 10 zugeordnet ist wenigstens ein Bearbeitungstisch 11, auf dem der Wafer einem Bearbeitungsprozess unterzogen wird. Grundsätzlich ist möglich, dass mehrere Bearbeitungsprozesse auf ein und demselben Bearbeitungstisch 11 durchgeführt werden. Es ist aber auch denkbar, dass für mehrere Bearbeitungsprozesse verschiedene Bearbeitungstische vorgesehen sind.

Die Wafer befinden sich vor Beginn des Bearbeitungsprozesses in einer Lagereinrichtung 12. In der Lagereinrichtung12, die aus einer oder mehreren Lagerkassetten bestehen kann, befindet sich in der Regel eine größere Anzahl von Wafern.

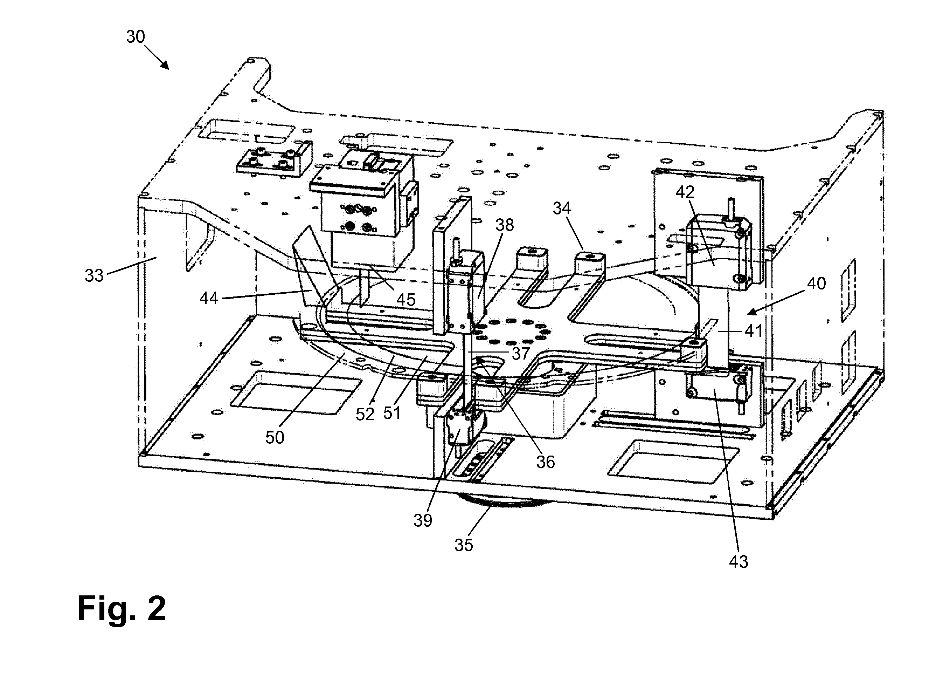

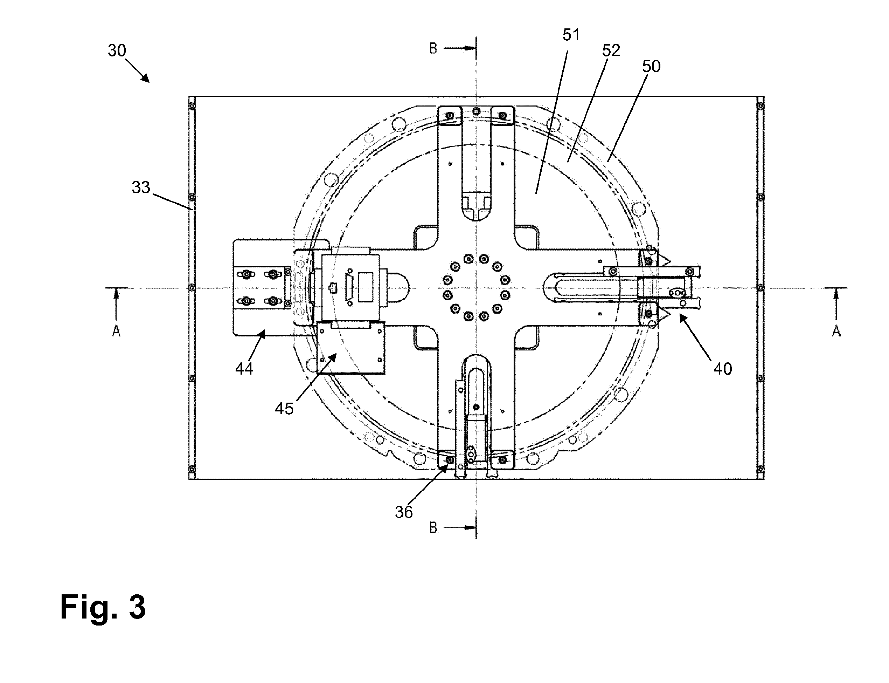

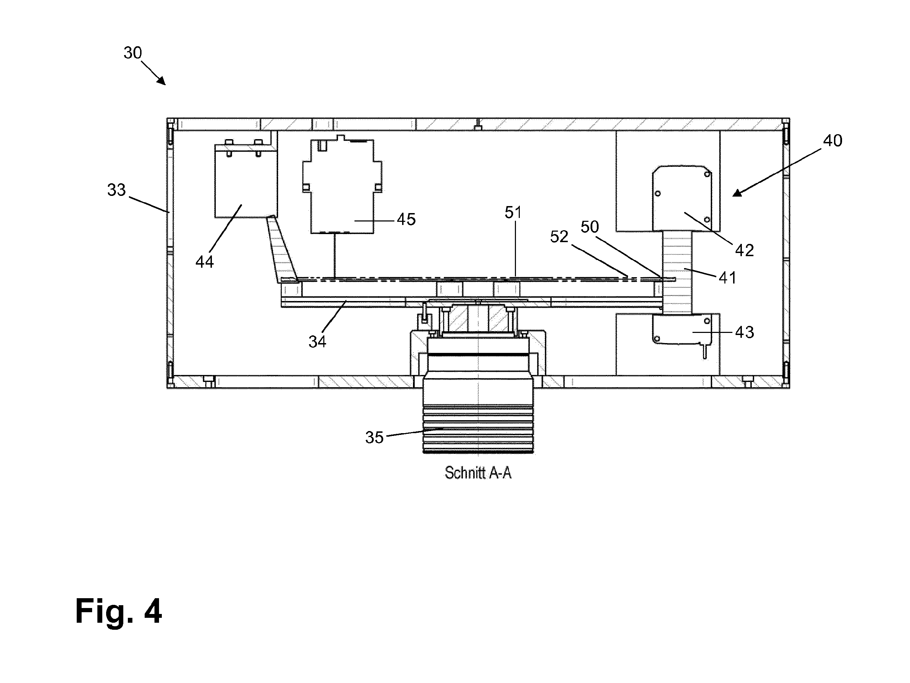

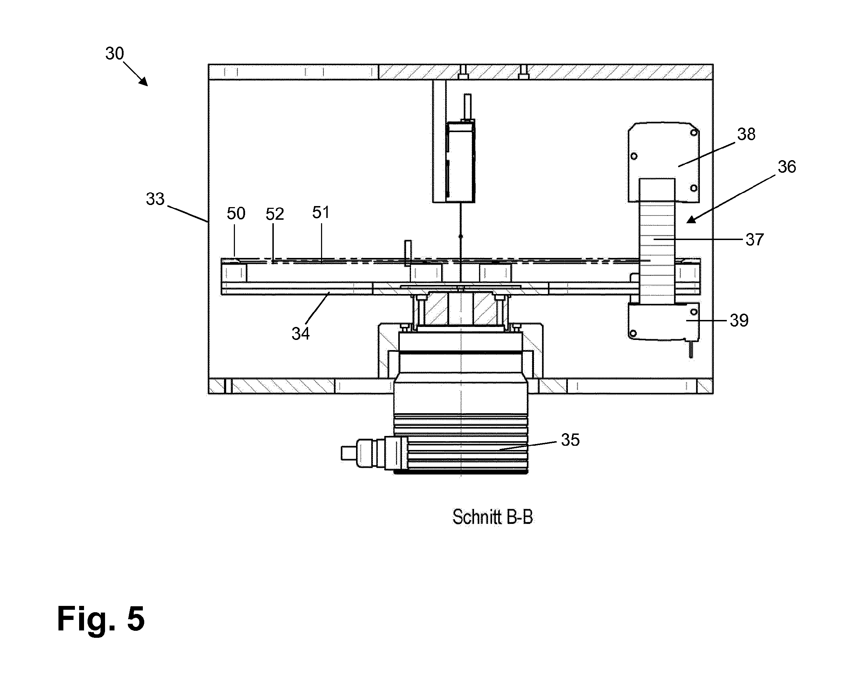

Gehandhabt werden die Wafer über eine Handhabungsvorrichtung 21 in Form eines Roboterarms, die Bestandteil einer Vorrichtung 20 zum Vorausrichten der Wafer ist. Die Vorrichtung 20 weist weiterhin eine Messvorrichtung 30 auf, die nachfolgend anhand der Figuren 2 bis 5 in größerem Detail beschrieben wird. Sowohl die Handhabungseinrichtung 21 als auch die Messvorrichtung 30 weisen jeweils eine Schnittstelle 22, 32 auf, über die zum Zwecke der Datenübertragung eine Kommunikationsverbindung 23 aufgebaut werden kann. Der Messvorrichtung 30 ist weiterhin einer Rechnereinrichtung 31 zugeordnet, in der die Daten, die an die Handhabungseinrichtung 21 übertragen werden sollen, erzeugt und/oder aufbereitet werden.

In den Figuren 2 bis 5 ist die Messvorrichtung 30 in verschiedenen Ansichten in größerem Detail dargestellt. Die Messvorrichtung 30 weist zunächst ein Gehäuse 33 auf, in dem eine Auflageeinrichtung 34 in Form einer Rahmenauflage mit Vakuum-Sauger vorgesehen ist. Die Auflageeinrichtung 34 kann über einen Antrieb 35 um 360 Grad gedreht werden, wobei es sich bei dem Antrieb 36 um einen Servo-Getriebemotor handelt.

Auf der Auflageeinrichtung 34 wird, wie in Figur 2 schematisch dargestellt ist, eine Einheit bestehend aus Rahmen 50 und Wafer 51 angeordnet, wobei der Wafer 51 über eine Folie 52 an dem Rahmen 50 anlaminiert ist.

Die Auflageeinrichtung 34 mit der darauf befindlichen Rahmen-Folien-Wafer-Einheit 50, 51, 52 befindet sich unterhalb von zwei Sensorelementen und kann mittels des Antriebs 35 unter diesen Sensorelementen gedreht werden. Bei einem ersten Sensorelement 36 handelt es sich um ein Sensorelement zum Ermitteln des Versatzes des Wafers 51 zum Zentrum der Messvorrichtung 30, insbesondere zum Zentrum der Auflageeinrichtung 34, wobei das Sensorelement 36 in Form eines an sich bekannten Kantensensors ausgebildet ist. Der Kantensensor emittiert ein Lichtband 37 von einem Emitter 38 zu einem Empfänger 39. Bei einem zweiten Sensorelement 40 handelt es sich um ein Sensorelement zum Ermitteln des Versatzes des Rahmens 50 zum Zentrum der Messvorrichtung 30, insbesondere zum Zentrum der Auflageeinrichtung 34, wobei das Sensorelement 40 in Form eines an sich bekannten Kantensensors ausgebildet ist. Auch dieser Kantensensor emittiert ein Lichtband 41 von einem Emitter 42 zu einem Empfänger 43.

Zudem weist die Messvorrichtung 30 zur Bestimmung der Identität des Rahmens 50 eine Leseeinrichtung 44 zum Lesen eines an dem Rahmen befindlichen Codes auf. Beispielsweise kann die Leseeinrichtung 44 zum Lesen eines Barcodes oder eines OCR-Textes (Optical Character Recognition) ausgebildet sein, wobei der Barcode oder der OCR-Text insbesondere die Rahmen-ID darstellt oder beinhaltet. Darüber hinaus weist die Messvorrichtung 30 zur Bestimmung der Identität des Wafers 51 eine Leseeinrichtung 45 zum Lesen eines an dem Wafer 51 befindlichen Codes auf. Beispielsweise kann auch die Leseeinrichtung 45 zum Lesen eines Barcodes oder eines OCR-Textes (Optical Character Recognition) ausgebildet sein, wobei der Barcode oder der OCR-Text insbesondere die Wafer-ID darstellt oder beinhaltet.

Darüber hinaus kann die Messvorrichtung 30 noch weitere Sensorelemente aufweisen, die aber in den Figuren nicht explizit dargestellt sind. Hierbei handelt es sich beispielsweise um ein Sensorelement zur Bestimmung der Winkelorientierung des Wafers 51 und/oder des Rahmens 50 in der Messvorrichtung 30. Zudem kann ein Sensorelement zum Bestimmen des Rahmenmaterials vorgesehen sein. Dadurch kann das Material des Rahmens 50 ermittelt werden. Beispielsweise kann ermittelt werden, ob der Rahmen 50 aus Kunststoff oder aus Metall besteht. Ein entsprechendes Sensorelement kann beispielsweise ein induktives Sensorelement sein.

Nachfolgend wird nun die Funktionsweise der Vorrichtung 20 zum Vorausrichten des Wafers mit der darin vorgesehenen Messvorrichtung 30, und damit der Ablauf des erfindungsgemäßen Verfahrens, beschrieben.

Die Messvorrichtung 30, die Bestandteil der erfindungsgemäßen Vorrichtung 20 zum Vorausrichten des Wafers 51 ist, ist ein Messgerät, das den Rahmen und den am Rahmen 50 angeordneten Wafer 51 über den Antrieb 35 unter den Sensorelementen 36 und 40 um 360 Grad dreht und dabei folgende Ergebnisse liefert:
Zunächst wird über das Sensorelement 40 die Außenkontur des Rahmens 50 vermessen. In der Rechnereinrichtung 31 (siehe Figur 1) entsteht eine Messkurve welche so ausgewertet wird, dass die Winkelorientierung, sowie der Versatz in X-Richtung und Y-Richtung zum Zentrum der Messvorrichtung 30, bestimmt werden. Zudem wird das Material des Rahmens 50 über einen induktiven Sensor ermittelt. Dabei wird insbesondere festgestellt, ob der Rahmen 50 aus Metall oder Kunststoff besteht. Weiterhin wird über das Sensorelement 36 die Außenkontur des Wafers 51 vermessen, wobei die Auswertung in gleicher Weise erfolgt wie beim Rahmen 50. Zusätzlich wird noch der Durchmesser des Wafers 51 über vier Punkte errechnet und die Rundheit des Wafers 51, insbesondere nach einem Expandier-Vorgang, bestimmt. Der Versatz der Mittelpunkte von Wafer 51 zu Rahmen 50 wird ebenso errechnet. Schließlich kann über die Leseeinrichtung 44, beispielsweise durch ein Lesen des Barcodes einer Etikette am Rahmen, die Identität des Rahmens 50 bestimmt werden In gleicher Weise kann über die Leseeinrichtung 45, beispielsweise durch ein Lesen eines OCR-Textes am Waferrand, die Identität des Wafers 51 bestimmt werden.

Die ermittelten Werte für den Versatz in X-Richtung und Y-Richtung vom Rahmen 50 und/oder vom Wafer 51 werden der Handhabungseinrichtung 21, beispielsweise dem Roboterarm, zur Korrektur der Übergabeposition übermittelt. Die Winkelorientierung wird an der Messvorrichtung 30 korrigiert.

Die Messvorrichtung 30 nimmt also alleine keine vollständige Vorausrichtung, das heißt ein Lage- und Winkelkorrigiertes Bereitstellen des Wafers 51, im Zentrum der Messvorrichtung 30, vor, sondern nur im Zusammenspiel gemeinsam mit einer geeigneten Handhabungseinrichtung 21, welche bevorzugt auch quer zur Handlingsachse verfahren kann.

### Bezugszeichenliste

- 10: Bearbeitungsstation für Wafer
- 11: Bearbeitungstisch
- 12: Lagereinrichtung

- 20: Vorrichtung zum Vorausrichten eines Wafers
- 21: Handhabungseinrichtung
- 22: Schnittstelle
- 23: Kommunikationsverbindung

- 30: Messvorrichtung
- 31: Rechnereinrichtung
- 32: Schnittstelle
- 33: Gehäuse
- 34: Auflageeinrichtung
- 35: Antrieb
- 36: Sensorelement zum Ermitteln des Versatzes des Wafers zum Zentrum der Messvorrichtung
- 37: Lichtband
- 38: Emitter
- 39: Empfänger
- 40: Sensorelement zum Ermitteln des Versatzes des Wafers zum Zentrum der Messvorrichtung
- 41: Lichtband
- 42: Emitter
- 43: Empfänger
- 44: Leseeinrichtung zur Bestimmung der Rahmenidentität
- 45: Leseeinrichtung zum Bestimmen der Waferidentität

- 50: Rahmen
- 51: Wafer
- 52: Folie

## Patentansprüche

1. Verfahren zum Vorausrichten eines flachen Substrats, insbesondere eines Wafers, welches über eine Folie an einem Rahmen angeordnet ist, vor einem nachfolgenden Bearbeitungsprozess,
**gekennzeichnet durch** folgende Schritte:
a) der Rahmen mit dem daran befindlichen flachen Substrat wird in einer Messvorrichtung, insbesondere auf einer Auflageeinrichtung der Messvorrichtung, angeordnet;
b) in der Messvorrichtung werden mittels wenigstens eines Sensorelements Versatzwerte bezüglich des Versatzes des Substrats zum Zentrum der Messvorrichtung und/oder des Versatzes des Rahmens zum Zentrum der Messvorrichtung, insbesondere zum Zentrum der Auflageeinrichtung, ermittelt;
c) die ermittelten Versatzwerte werden über eine der Messvorrichtung zugeordnete Schnittstelle an eine Handhabungseinrichtung zum Handhaben des Substrats übertragen;
d) die Handhabungseinrichtung wird anhand der empfangenen Versatzwerte entsprechend bewegt, derart, dass der Rahmen mit dem daran befindlichen Substrat ausgerichtet aufgenommen wird oder dass der Rahmen mit dem daran befindlichen Substrat ausgerichtet an einer Zielposition abgeladen wird.

2. Verfahren nach Anspruch 1, **dadurch gekennzeichnet, dass** über das wenigstens eine Sensorelement der Mittelpunkt des Substrats und/oder des Rahmens bestimmt wird, und dass daraus Versatzwerte bezüglich des Versatzes des Substrats und/oder des Versatzes des Rahmens ermittelt werden, und/oder dass über das wenigstens eine Sensorelement die Kante des Substrats und/oder des Rahmens ermittelt wird und dass daraus Versatzwerte bezüglich des Versatzes des Substrats und/oder des Versatzes des Rahmens ermittelt werden.

3. Verfahren nach Anspruch 1 oder 2, **dadurch gekennzeichnet, dass** die Außenkante des Rahmens und/oder die Außenkante des Substrats vermessen wird, dass aus den ermittelten Messwerten eine Messkurve erzeugt wird, und dass die erzeugte Messkurve ausgewertet wird, insbesondere derart, dass daraus der Versatz in X-Richtung und in Y-Richtung zum Zentrum der Messvorrichtung bestimmt wird.

4. Verfahren nach einem der Ansprüche 1 bis 3, **dadurch gekennzeichnet, dass** zusätzlich der Durchmesser des Substrats ermittelt wird, insbesondere indem der Durchmesser über zwei oder mehr Punkte, bevorzugt über vier Punkte, errechnet wird.

5. Verfahren nach einem der Ansprüche 1 bis 4, **dadurch gekennzeichnet, dass** in der Messvorrichtung der Versatz des Mittelpunkts des Substrats zum Mittelpunkt des Rahmens errechnet wird.

6. Verfahren nach Anspruch 5, **dadurch gekennzeichnet, dass** der errechnete Versatz des Rahmens zum Substrat von der Messvorrichtung über die Schnittstelle an die Handhabungseinrichtung zur Korrektur der Übergabeposition übermittelt wird.

7. Verfahren nach einem der Ansprüche 1 bis 6, **dadurch gekennzeichnet, dass** in der Messvorrichtung die Winkelorientierung des Substrats und/oder des Rahmens ermittelt wird und dass die Winkelposition insbesondere in der Messvorrichtung korrigiert wird.

8. Verfahren nach einem der Ansprüche 1 bis 7, **dadurch gekennzeichnet, dass** das Substrat und/oder der Rahmen unter dem wenigstens einen Sensorelement gedreht wird, insbesondere um 360 Grad.

9. Verfahren nach einem der Ansprüche 1 bis 8, **dadurch gekennzeichnet, dass** über ein Sensorelement zur Materialbestimmung das Material des Rahmens bestimmt wird.

10. Verfahren nach einem der Ansprüche 1 bis 9, **dadurch gekennzeichnet, dass** zur Bestimmung der Identität des Rahmens ein an dem Rahmen befindlicher Code über eine Leseeinrichtung gelesen wird und/oder dass zur Bestimmung der Identität des Substrats ein an dem Substrat befindlicher Code über eine Leseeinrichtung gelesen wird.

11. Vorrichtung (20) zum Vorausrichten eines flachen Substrats, insbesondere eines Wafers (51), welches über eine Folie (52) an einem Rahmen (50) angeordnet ist, vor einem nachfolgenden Bearbeitungsprozess, aufweisend eine Messvorrichtung (30), mit einer Auflageeinrichtung (34) zum Aufnehmen des Rahmens mit dem daran befindlichen Substrat, wobei die Auflageeinrichtung (34) insbesondere über einen Antrieb (35) um 360 Grad drehbar ist, mit wenigstens einem Sensorelement (36) zum Ermitteln des Versatzes des Substrats zum Zentrum der Messvorrichtung (30) und/oder wenigstens einem Sensorelement (40) zum Ermitteln des Versatzes des Rahmens (50) zum Zentrum der Messvorrichtung (30), und mit einer Schnittstelle (32) zum Übertragen der ermittelten Versatzwerte an eine Handhabungseinrichtung (21) zum Handhaben des Substrats.

12. Vorrichtung nach Anspruch 11, **dadurch gekennzeichnet, dass** diese eine Handhabungseinrichtung (21) zum Handhaben des Substrats aufweist, dass die Handhabungseinrichtung (21) eine Schnittstelle (22) zum Empfangen von Versatzwerten von der Messvorrichtung (30) aufweist und dass die Handhabungseinrichtung (21) derart bereitgestellt ist, dass sie in der Lage ist, dass sie anhand der empfangenen Versatzwerte entsprechend bewegt wird, derart, dass der Rahmen (50) mit dem daran befindlichen Substrat ausgerichtet aufgenommen wird oder dass der Rahmen (50) mit dem daran befindlichen Substrat ausgerichtet an einer Zielposition abgeladen wird.

13. Vorrichtung nach Anspruch 11 oder 12, **dadurch gekennzeichnet, dass** das wenigstens eine Sensorelement (36) zum Ermitteln des Versatzes des Substrats zum Zentrum der Messvorrichtung (30) und/oder das wenigstens eine Sensorelement (40) zum Ermitteln des Versatzes des Rahmens (50) zum Zentrum der Messvorrichtung (30) als optisches Sensorelement, insbesondere als CCD-Laser-Sensorelement, ausgebildet ist.

14. Vorrichtung nach einem der Ansprüche 11 bis 13, **dadurch gekennzeichnet, dass** diese ein Sensorelement zum Bestimmen des Rahmenmaterials aufweist und/oder dass diese zur Bestimmung der Identität des Rahmens eine Leseeinrichtung (44) zum Lesen eines an dem Rahmen befindlichen Codes aufweist und/oder dass diese zur Bestimmung der Identität des Substrats eine Leseeinrichtung (45) zum Lesen eines an dem Substrat befindlichen Codes aufweist.

15. Vorrichtung nach einem der Ansprüche 11 bis 14, **dadurch gekennzeichnet, dass** diese Mittel zur Durchführung des Verfahrens nach einem der Ansprüche 1 bis 10 aufweist.
